# EUROPEAN PATENT SPECIFICATION

(11) **EP 1 117 853 B1**
(45) Date of publication and mention of the grant of the patent: **06.11.2002**
(21) Application number: 00953799.4
(22) Date of filing: 02.08.2000
(51) Int. Cl.: C23C 14/56, C23C 14/46

(54) **ELECTRON BEAM PHYSICAL VAPOR DEPOSITION APPARATUS**
ELEKTRONSTRAHL-PVD-VORRICHTUNG
DISPOSITIF DE DEPOT PHYSIQUE EN PHASE VAPEUR A FAISCEAU D'ELECTRONS

(30) Priority: 04.08.1999 US 147230 P; 24.07.2000 US 621758
(43) Date of publication of application: 25.07.2001
(73) Proprietor: GENERAL ELECTRIC COMPANY, Schenectady, NY 12345 (US)
(72) Inventor: BRUCE, Robert, William, Loveland, OH 45140 (US); EVANS, John, Douglas, Sr., Springfield, OH 45502 (US); BETSCHER, Keith, H., West Chester, OH 45069 (US); MARICOCCHI, Antonio, Frank, Loveland, OH 45140 (US); WORTMAN, David, John, Niskayuna, NY 12309 (US); BOWLIN, William, Allen, Indianapolis, IN 46234 (US); DILLON, Harold, Phillips, II, Jasper, GA 30143 (US)
(74) Representative: Goode, Ian Roy
(86) International application number: US0021087
(87) International publication number: WO01011109

(56) References cited:
- GB-A- 869 397
- GB-A- 2 095 704
- US-A- 3 656 454
- US-A- 5 882 415

## Description

This application claims benefit of Provisional Patent Application No. 60/147,230, filed August 4, 1999.

### CROSS-REFERENCE TO RELATED APPLICATIONS

This application is related to co-pending United States patent application Serial No. [Attorney Docket No. 13DV-13041], the contents of which are incorporated herein by reference.

### FIELD OF THE INVENTION

This invention generally relates to an electron beam physical vapor deposition coating apparatus. More particularly, this invention is directed to a movable platform system that enables chambers of such a coating apparatus to be repositioned while causing minimal interference with the operation of the apparatus.

### BACKGROUND OF THE INVENTION

Thermal barrier coatings (TBC) have found wide use for thermally insulating the exterior surfaces of high-temperature gas turbine components in order to minimize the service temperatures of such components. Various ceramic materials have been employed as the TBC, particularly zirconia (ZrO₂) stabilized by yttria (Y₂O₃), magnesia (MgO) or other oxides. These particular materials are widely employed in the art because they can be readily deposited by plasma spray and vapor deposition techniques. An example of the latter is electron beam physical vapor deposition (EBPVD), which produces a thermal barrier coating having a columnar grain structure that is able to expand with its underlying substrate without causing damaging stresses that lead to spallation, and therefore exhibits enhanced strain tolerance.

The process of depositing ceramic coatings (e.g., TBC) by EBPVD using a coating apparatus scaled for production generally entails initially loading the components to be coated into a loading chamber. The pressure within the loading chamber is typically lowered to 10⁻² mbar or less prior to transferring the components to a preheat chamber, where the components are heated to typically 800°C or more in order to promote adhesion of the coating on the component. From the preheat chamber, the components are transferred to a heated coating chamber maintained at a low pressure, typically about 0.005 mbar. The component is supported in proximity to an ingot of the ceramic coating material to be deposited, and an electron beam is projected onto the ingot so as to melt the surface of the ingot and produce a vapor that deposits onto the component, forming an adhesive ceramic layer.

Advanced EBPVD apparatuses used for production are often configured to enable coated components to be removed from the coating chamber and replaced with preheated uncoated components without shutting down the apparatus, so that a continuous operation is achieved. The continuous operation of the apparatus during this time can be termed a "campaign," with greater numbers of components successfully coated during the campaign corresponding to greater processing and economic efficiencies.

In view of the above, there is considerable motivation to increase the number of components that can be coated within a single campaign, reduce the amount of time required to introduce and remove components from the coating chamber, and reduce the amount of time required to perform maintenance on the apparatus between campaigns. However, difficulties can arise in view of the complex equipment necessary to move extremely hot components through the loading, preheat and coating chambers, as well as the difficulty of maintaining such equipment of an advanced EBPVD apparatus.

### BRIEF SUMMARY OF THE INVENTION

The present invention is an electron beam physical vapor deposition (EBPVD) apparatus for producing a coating (e.g., a ceramic thermal barrier coating) on an article, and more particularly a movable platform system that facilitates the relative positioning of the loading and preheat chambers of an EBPVD apparatus intended for use in production. The platform system of this invention surrounds at least one loading chamber, and is movable relative to the preheat chamber so as to bring the loading chamber into and out of alignment with the preheat chamber. Importantly, the platform system has an extremely low elevational profile, preferably not more than 2.5 cm, so as to essential eliminate any risk to the operators of the EBPVD apparatus during repositioning of the loading chamber.

Other objects and advantages of this invention will be better appreciated from the following detailed description.

### BRIEF DESCRIPTION OF THE DRAWINGS

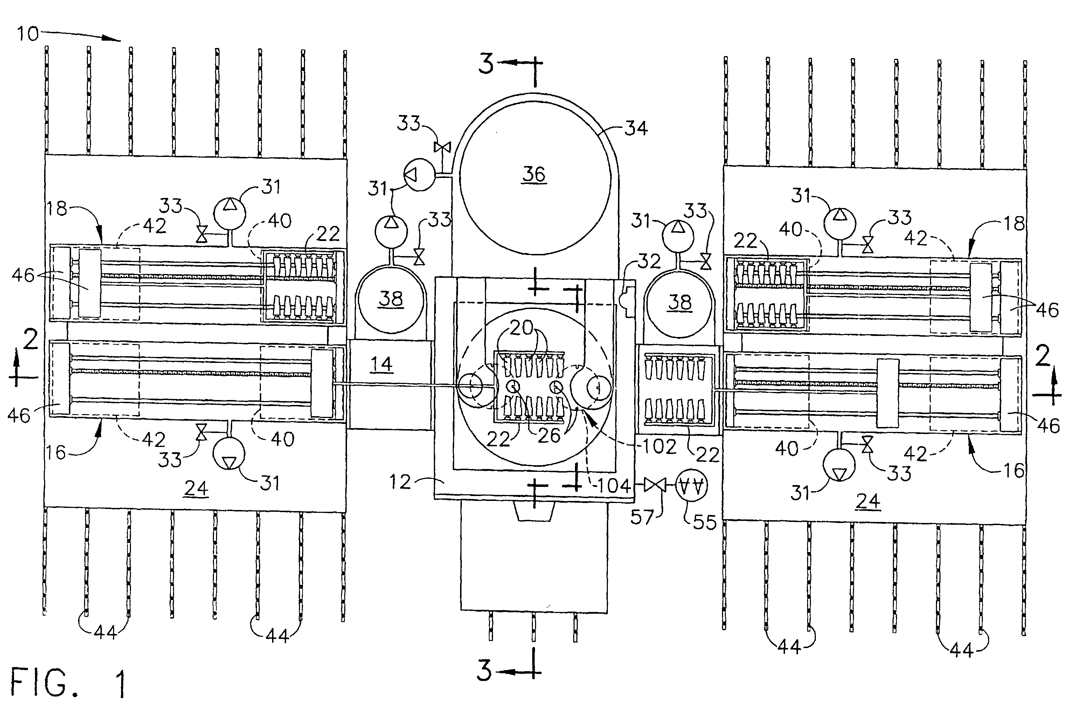

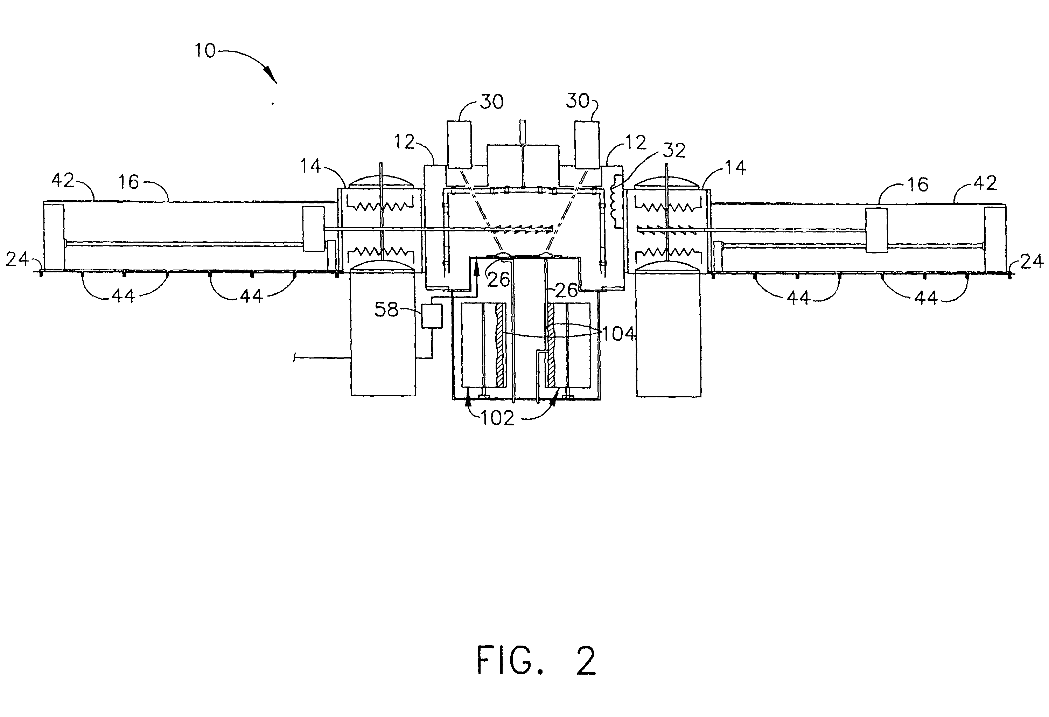

Figures 1 and 2 are schematic top and front views, respectively, of an electron beam physical vapor deposition apparatus equipped with a movable platform system in accordance with this invention.

### DETAILED DESCRIPTION OF THE INVENTION

An EBPVD apparatus 10 in accordance with this invention is generally depicted in Figures 1 and 2. With the apparatus 10, a ceramic thermal barrier coating can be deposited on a metal component intended for operation within a thermally hostile environment. Notable examples of such components include the high and low pressure turbine nozzles and blades, shrouds, combustor liners and augmentor hardware of gas turbine engines.

For purposes of illustrating the invention, the EBPVD apparatus 10 is shown in Figures 1 and 2 as including a coating chamber 12, a pair of preheat chambers 14, and two pairs of loading chambers 16 and 18, so that the apparatus 10 has a symmetrical configuration. The front loading chambers 16 are shown as being aligned with their preheat chambers 14, with parts 20 originally loaded on a rake 22 within the lefthand loading chamber 16 having been transferred to the lefthand preheat chamber 14 and, as depicted in Figure 1, into the coating chamber 12. With the symmetrical configuration of the apparatus 10, while the parts 20 loaded through the front lefthand loading chamber 16 are being coated within the coating chamber 12, a second batch of parts in the front righthand loading chamber 16 can be preheated in the righthand preheat chamber 14, a third batch of parts can be loaded into the rear lefthand loading chamber 18, and a fourth batch of parts can be unloaded from the rear righthand loading chamber 18. Consequently, four process stages can occur simultaneously with the preferred EBPVD apparatus 10 of this invention.

Within the coating chamber 12, a ceramic coating is deposited on the parts 20 by melting and evaporating ingots 26 of the desired ceramic material with electron beams produced by electron beam (EB) guns 30. Intense heating of the ingots 26 by the electron beams causes the surface of each ingot 26 to melt, forming molten ceramic pools from which molecules of the ceramic material evaporate, travel upwardly, and then deposit on the surfaces of the parts 20, producing the desired ceramic coating whose thickness will depend on the duration of the coating process.

The subatmospheric pressure required within the coating chamber 12 is controlled by the rate at which gases can be pumped from the chamber 12, and the flow rate into the chamber 12 of desired gases, such as oxygen and argon. In Figure 2, gases are shown as being introduced into the coating chamber 12 through a valve 58 located near the coating chamber 12. The flow rates of the gases are individually controlled based on the targeted process pressure and oxygen partial pressure. After rough pumpdown with mechanical pumps 31, cryogenic and diffusion pumps 32 and 34 of types known in the art can be employed to evacuate the coating chamber 12 prior to and during the deposition process. A separate pair of diffusion pumps 38 is shown as being employed to evacuate the preheat chambers 14. As indicated in Figure 1, the diffusion pump 34 for the coating chamber 12 is equipped with a throttle valve 36 to regulate the operation of the pump 34 at relatively high pressures, e.g., above 0.010 mbar. The diffusion pumps 38 for the preheat chambers 14 are also preferably equipped with throttle valves for the same purpose.

According to the present invention, the preheat and loading chambers 14, 16 and 18 are required to move relative to each other so that the loading chambers 16 and 18 can be selectively aligned with their respective preheat chambers 14. For example, when the front lefthand loading chamber 16 is brought into alignment with the lefthand preheat chamber 14 to allow the parts 20 to be inserted into the coating chamber 12, the rear lefthand loading chamber 18 is set back from the lefthand preheat chamber 14, so that parts can be simultaneously loaded or unloaded from the rake 22 of the rear lefthand loading chamber 18. The coating, preheat and loading chambers 12, 14, 16 and 18 are connected by valves (not shown) that achieve a vacuum seal between these chambers. Consequently, the valves must be capable of numerous cycles at relatively high temperatures and repeatedly provide a reliable vacuum seal between chambers. Seal designs suitable for this purpose are known in the art, and therefore will not be discussed in any detail.

The required mobility of the loading chambers 16 and 18 is achieved in accordance with this invention with two low-profile movable platforms 24 with which paired loading chambers 16 and 18 are supported. In addition to selectively aligning the loading chambers 16 and 18 with the preheat chambers 14, each platform 24 is also preferably movable to a maintenance position, in which neither of its loading chambers 16 and 18 is aligned with its preheat chamber 14, so that the interiors of the preheat and loading chambers 14, 16 and 18 can be accessed for cleaning. The platforms 24 are preferably at least in part supported on roller bearings 44 mounted in the floor, though it is foreseeable that a different bearing design could be used. In addition, the bearings 44 could be mounted within the platforms 24 instead of the floor. In a preferred embodiment, the platforms 24 have a generally two-part construction in which platforms are mounted to the sides or bases of the loading chambers 16 and 18 and further supported by the bearings 44.

Importantly, each platform 24 has a low elevational profile (projection above the floor) of not more than one inch (about 2.5 cm). The low-profile of the platforms 24, along with a chamfer preferably provided along the outer edge of the platform 24, essentially eliminates the potential for an operator tripping on the edges of the platforms 24. The platforms 24 are shown as having sufficiently large surfaces to provide walkways along the loading chambers 16 and 18, as well as storage area for benches and other support equipment. Other stationary objects surrounding the apparatus 10 are preferably positioned away from the edge of the platform 24 to avoid an operator being pinched by the platform 24 when it is repositioned.

While our invention has been described in terms of a preferred embodiment, it is apparent that other forms could be adopted by one skilled in the art. Accordingly, the scope of our invention is to be limited only by the following claims.

## Claims

1. An electron beam physical vapor deposition coating apparatus (10) comprising:
a coating chamber (12) operable at an elevated temperature and a subatmospheric pressure;
support means (22) for supporting an article (20) in the coating chamber (12);
a preheat chamber (14) adjacent and aligned with the coating chamber (12), the preheat chamber (14) being operable to preheat the article (20) supported by the support means (22) within the preheat chamber (14) prior to the support means (22) introducing the article (20) into the coating chamber (12);
a loading chamber (16,18) adjacent and aligned with the preheat chamber (14), the loading chamber (16,18) having an access (40) through which the article (20) is loaded onto the support means (22) prior to the support means (22) sequentially introducing the article (20) into the preheat and coating chambers (14,12); and
a movable platform (24) on which the loading chamber (16,18) is supported, the movable platform (24) being movable relative to the preheat chamber (14) so as to bring the loading chamber (16,18) into and out of alignment with the preheat chamber (14), the movable platform (24) having an elevational profile of not more than 2.5 cm.

2. An electron beam physical vapor deposition coating apparatus (10) according to claim 1, wherein the preheat chamber (14) is mounted to a surface and the movable platform (24) is movably supported above the surface.

3. An electron beam physical vapor deposition coating apparatus (10) according to claim 1, further comprising bearings (44) mounted in the surface and supporting the movable platform (24).

4. An electron beam physical vapor deposition coating apparatus (10) according to claim 1, wherein the movable platform (24) comprises a walkway on a surface region of the movable platform (24) adjacent the loading chamber (16,18)

5. An electron beam physical vapor deposition coating apparatus (10) according to claim 1, further comprising:
a second support means (22) for supporting a second article (20) in the preheat and coating chamber (12);
a second loading chamber (16,18) adjacent to the loading chamber (16,18), the second loading chamber (16,18) having an access (40) through which the second article (20) is loaded onto the second support means (22), the second loading chamber (16,18) being supported on the movable platform (24) so that the second loading chamber (16,18) is also movable into and out of alignment with the preheat chamber (14).

6. An electron beam physical vapor deposition coating apparatus (10) according to claim 5, wherein the movable platform (24) is movable between a first position in which the loading chamber (16,18) is aligned with the preheat chamber (14) and the second loading chamber (16,18) is not aligned with the preheat chamber (14), a second position in which the loading chamber (16,18) is not aligned with the preheat chamber (14) and the second loading chamber (16,18) is aligned with the preheat chamber (14), and a third position in which neither the loading chamber (16,18) nor the second loading chamber (16,18) is aligned with the preheat chamber (14).

7. An electron beam physical vapor deposition coating apparatus (10) comprising:
a coating chamber (12) operable at an elevated temperature and a subatmospheric pressure;
an electron beam gun (30) for projecting an electron beam (28) into the coating chamber (12);
first support means (22) for supporting a first article (20) in the coating chamber (12);
a preheat chamber (14) mounted to a surface so as to be adjacent and aligned with the coating chamber (12), the preheat chamber (14) being operable to preheat the first article (20) supported by the first support means (22) within the preheat chamber (14) prior to the first support means (22) introducing the first article (20) into the coating chamber (12);
a first loading chamber (16,18) adjacent and aligned with the preheat chamber (14) and opposite the coating chamber (12), the first loading chamber (16,18) having an access (40) through which the first article (20) is loaded onto the first support means (22) prior to the first support means (22) sequentially introducing the first article (20) into the preheat and coating chambers (14,12);
second support means (22) for supporting a second article (20) in the preheat and coating chamber (12);
a second loading chamber (16,18) adjacent to the first loading chamber (16,18), the second loading chamber (16,18) having an access (40) through which the second article (20) is loaded onto the second support means (22);
a movable platform (24) with an upper surface not more than 2.5 cm above the surface, the first and second loading chambers (16,18) being supported by the movable platform (24) so that movement thereof causes the first and second loading chambers (16,18) to be brought into and out of alignment with the preheat chamber (14); and
bearings (44) supporting the movable platform (24) above the surface.

8. An electron beam physical vapor deposition coating apparatus (10) according to claim 7, wherein the movable platform (24) is movable between a first position in which the first loading chamber (16,18) is aligned with the preheat chamber (14) and the second loading chamber (16,18) is not aligned with the preheat chamber (14), a second position in which the first loading chamber (16,18) is not aligned with the preheat chamber (14) and the second loading chamber (16,18) is aligned with the preheat chamber (14), and a third position in which neither the first loading chamber (16,18) nor the second loading chamber (16,18) is aligned with the preheat chamber (14).

9. An electron beam physical vapor deposition coating apparatus (10) according to claim 7, wherein the movable platform (24) comprises a first walkway on a first surface region of the movable platform (24) adjacent the first loading chamber (16,18), and a second walkway on a second surface region of the movable platform (24) adjacent the second loading chamber (16,18).

10. An electron beam physical vapor deposition coating apparatus (10) according to claim 7, wherein the bearings (44) are mounted in the surface.

## Patentansprüche

1. Elektronenstrahl-PVD-Beschichtungsvorrichtung (10) enthaltend:
eine Beschichtungskammer (12), die bei einer erhöhten Temperatur und einem subatmosphärischen Druck betrieben werden kann,
eine Haltevorrichtung (22) zum Haltern eines Gegenstandes (20) in der Beschichtungskammer (12),
eine Vorheizkammer (14) neben und ausgerichtet mit der Beschichtungskammer (12), wobei die Vorheizkammer (14) den Gegenstand (20), der von der Haltevorrichtung (22) in der Vorheizkammer (14) gehaltert ist, vorheizen kann, bevor die Haltevorrichtung (22) den Gegenstand (20) in die Beschichtungskammer (12) einführt,
eine Ladekammer (16, 18) neben und ausgerichtet mit der Vorheizkammer (14), wobei die Ladekammer (16, 18) einen Zugang (40) aufweist, durch den der Gegenstand (20) auf die Haltevorrichtung (22) geladen wird, bevor die Haltevorrichtung (22) anschließend den Gegenstand (20) in die Vorheiz- und Beschichtungskammern (14, 12) einführt, und
eine bewegbare Plattform (24), auf der die Ladekammer (16, 18) gehaltert ist, wobei die bewegbare Plattform (24) relativ zu der Vorheizkammer (14) bewegbar ist, um so die Ladekammer (16, 18) in und aus der Ausrichtung mit der Vorheizkammer (14) zu bringen, wobei die bewegbare Plattform (24) ein Höhenprofil von nicht mehr als 2,5cm hat.

2. Elektronenstrahl-PVD-Beschichtungsvorrichtung (10) nach Anspruch 1, wobei die Vorheizkammer (14) auf einer Oberfläche angebracht ist und die bewegbare Plattform (24) über der Oberfläche bewegbar gehaltert ist.

3. Elektronenstrahl-PVD-Beschichtungsvorrichtung (10) nach Anspruch 1, ferner Lager (44) enthaltend, die in der Oberfläche angebracht sind und die bewegbare Plattform (24) haltern.

4. Elektronenstrahl-PVD-Beschichtungsvorrichtung (10) nach Anspruch 1, wobei die bewegbare Plattform (24) einen Laufgang auf einem Oberflächenbereich des bewegbaren Plattform (24) neben der Ladekammer (16, 18) aufweist.

5. Elektronenstrahl-PVD-Beschichtungsvorrichtung (10) nach Anspruch 1, ferner enthaltend:
eine zweite Haltevorrichtung (22) zum Haltern eines zweiten Gegenstandes (20) in der Vorheiz- und Beschichtungskammer (12),
eine zweite Ladekammer (16, 18) neben der Ladekammer (16, 18), wobei die zweite Ladekammer (16, 18) einen Zugang (40) hat, durch den der zweite Gegenstand (20) auf die zweite Haltevorrichtung (22) geladen wird, wobei die zweite Ladekammer (16, 18) so auf der bewegbaren Plattform (24) gehaltert wird, daß die zweite Ladekammer (16, 18) auch in und aus der Ausrichtung mit der Vorheizkammer (14) bewegbar ist.

6. Elektronenstrahl-PVD-Beschichtungsvorrichtung (10) nach Anspruch 5, wobei die bewegbare Plattform (24) zwischen einer ersten Stellung, in der die Ladekammer (16, 18) mit der Vorheizkammer (14) ausgerichtet ist und die zweite Ladekammer (16, 18) nicht mit der Vorheizkammer (14) ausgerichtet ist, einer zweiten Stellung, in der die Ladekammer (16, 18) nicht mit der Vorheizkammer (14) ausgerichtet ist und die zweite Ladekammer (16, 18) mit der Vorheizkammer (14) ausgerichtet ist, und einer dritten Stellung bewegbar ist, in der weder die Ladekammer (16, 18) noch die zweite Ladekammer (16, 18) mit der Vorheizkammer (14) ausgerichtet sind.

7. Elektronenstrahl-PVD-Beschichtungsvorrichtung (10) enthaltend:
eine Beschichtungskammer (12), die bei einer erhöhten Temperatur und einem subatmosphärischen Druck betrieben werden kann,
eine Elektronenstrahlkanone (30) zum Projizieren eines Elektronenstrahls (28) in die Beschichtungskammer (12),
eine erste Haltevorrichtung (22) zum Haltern eines ersten Gegenstandes (20) in der Beschichtungskammer (12),
eine Vorheizkammer (14), die so auf einer Oberfläche angebracht ist, daß sie sich neben und ausgerichtet mit der Beschichtungskammer (12) befindet, wobei die Vorheizkammer (14) den Gegenstand (20), der von der ersten Haltevorrichtung (22) in der Vorheizkammer (14) gehaltert ist, vorheizen kann, bevor die erste Haltevorrichtung (22) den ersten Gegenstand (20) in die Beschichtungskammer (12) einführt,
eine erste Ladekammer (16, 18) neben und ausgerichtet mit der Vorheizkammer (14) und gegenüber der Beschichtungskammer (12), wobei die erste Ladekammer (16, 18) einen Zugang (40) aufweist, durch den der erste Gegenstand (20) auf die erste Haltevorrichtung (22) geladen wird, bevor die erste Haltevorrichtung (22) anschließend den ersten Gegenstand (20) in die Vorheiz- und Beschichtungskammern (14, 12) einführt,
eine zweite Haltevorrichtung (22) zum Haltern eines zweiten Gegenstandes (20) in der Vorheiz- und Beschichtungskammer (12),
eine zweite Ladekammer (16, 18) neben der ersten Ladekammer (16, 18), wobei die zweite Ladekammer (16, 18) einen Zugang (40) aufweist, durch den der zweite Gegenstand (20) auf die zweite Haltevorrichtung (22) geladen wird,
eine bewegbare Plattform (24) mit einer oberen Fläche, die nicht mehr als 2,5 cm über der Oberfläche ist, wobei die ersten und zweiten Ladekammern (16, 18) durch die bewegbare Plattform (24) so gehalten sind, daß ihre Bewegung bewirkt, daß die ersten und zweiten Ladekammern (16, 18) in und aus der Ausrichtung mit der Vorheizkammer (14) gebracht werden, und
Lager (44), die die bewegbare Plattform (24) über der Oberfläche halten.

8. Elektronenstrahl-PVD-Beschichtungsvorrichtung (10) nach Anspruch 7, wobei die bewegbare Plattform (24) zwischen einer ersten Stellung, in der die erste Ladekammer (16, 18) mit der Vorheizkammer (14) ausgerichtet ist und die zweite Ladekammer (16, 18) nicht mit der Vorheizkammer (14) ausgerichtet ist, einer zweiten Stellung, in der die erste Ladekammer (16, 18) nicht mit der Vorheizkammer (14) ausgerichtet ist und die zweite Ladekammer (16, 18) mit der Vorheizkammer (14) ausgerichtet ist, und einer dritten Stellung bewegbar ist, in der weder die erste Ladekammer (16, 18) noch die zweite Ladekammer (16, 18) mit der Vorheizkammer (14) ausgerichtet sind.

9. Elektronenstrahl-PVD-Beschichtungsvorrichtung (10) nach Anspruch 7, wobei die bewegbare Plattform (24) einen ersten Laufgang auf einem ersten Oberflächenbereich der bewegbaren Plattform (24) neben der ersten Ladekammer (16, 18) und einen zweiten Laufgang auf einem zweiten Oberflächenbereich der bewegbaren Plattform (24) neben der zweiten Ladekammer (16, 18) aufweist.

10. Elektronenstrahl-PVD-Beschichtungsvorrichtung (10) nach Anspruch 7, wobei die Lager (44) auf der Oberfläche angebracht sind.

## Revendications

1. Dispositif de dépôt physique en phase vapeur à faisceau d'électrons (10) comprenant :
une chambre de revêtement (12) pouvant fonctionner à une température élevée et une pression subatmosphérique;
un moyen formant support (22) pour supporter un article (20) dans la chambre de revêtement (12);
une chambre de préchauffage (14) adjacente à la chambre de revêtement (12) et alignée avec celle-ci, la chambre de préchauffage (14) pouvant fonctionner pour préchauffer l'article (20) supporté par le moyen formant support (22) à l'intérieur de la chambre de préchauffage (14) avant l'introduction par le moyen forment support (22) de l'article (20) dans la chambre de revêtement (12);
une chambre de chargement (16, 18) adjacente à la chambre de préchauffage (14) et alignée avec celle-ci, la chambre de préchauffage (16, 18) ayant un accès (40) par lequel l'article (20) est chargé sur le moyen formant support (22) avant l'introduction consécutive par le moyen formant support (22) de l'article (20) dans les chambres de préchauffage et de revêtement (14, 12); et
une plate-forme mobile (24) sur laquelle est supportée la chambre de chargement (16, 18), la plate-forme mobile (24) étant mobile par rapport à la chambre de préchauffage (14) de manière à mettre la chambre de chargement (16,18) en et hors d'alignement avec la chambre de préchauffage (14), la plate-forme mobile (24) ayant un profil en élévation ne dépassant par 2,5 cm.

2. Dispositif de dépôt physique en phase vapeur à faisceau d'électrons (10) selon la revendication 1, dans lequel la chambre de préchauffage (14) est montée sur une surface et la plate-forme mobile (24) est supportée en pouvant se déplacer au-dessus de la surface.

3. Dispositif de dépôt physique en phase vapeur à faisceau d'électrons (10) selon la revendication 1, comprenant en outre des appuis (44) montés dans la surface et supportant la plate-forme mobile (24).

4. Dispositif de dépôt physique en phase vapeur à faisceau d'électrons (10) selon la revendication 1, dans lequel la plate-forme mobile (24) comprend une passerelle sur une région de surface de la plate-forme mobile (24) adjacente à la chambre de chargement (16, 18).

5. Dispositif de dépôt physique en phase vapeur à faisceau d'électrons (10) selon la revendication 1, comprenant en outre :
un second moyen formant support (22) pour supporter un second article (20) dans la chambre de préchauffage et de revêtement (12);
une seconde chambre de chargement (16, 18) adjacente à la chambre de chargement (16, 18), la seconde chambre de chargement (16, 18) ayant un accès (40) par lequel le second article (20) est chargé sur le second moyen formant support (22), la seconde chambre de chargement (16, 18) étant supportée sur la plate-forme mobile (24) de telle manière que la seconde chambre de chargement (16, 18) peut également être mise en et hors d'alignement avec la chambre de préchauffage (14).

6. Dispositif de dépôt physique en phase vapeur à faisceau d'électrons (10) selon la revendication 5, dans lequel la plate-forme mobile (24) peut se déplacer entre une première position dans laquelle la chambre de chargement (16, 18) est alignée avec la chambre de préchauffage (14) et la seconde chambre de chargement (16, 18) n'est pas alignée avec la chambre de préchauffage (14), une deuxième position dans laquelle la chambre de chargement (16, 18) n'est pas alignée avec la chambre de préchauffage (14) et la seconde chambre de chargement (16,18) est alignée avec la chambre (14), et une troisième position dans laquelle ni la chambre de chargement (16, 18), ni la seconde chambre de chargement (16, 18) ne sont alignées avec la chambre de préchauffage (14).

7. Dispositif de dépôt physique en phase vapeur à faisceau d'électrons (10) comprenant :
une chambre de revêtement (12) pouvant fonctionner à une température élevée et à une pression subatmosphérique;
un canon à faisceau d'électrons (30) pour projeter un faisceau d'électrons (28) dans la chambre de revêtement (12);
un premier moyen formant support (22) pour supporter un premier article (20) dans la chambre de revêtement (12);
une chambre de préchauffage (14) montée sur une surface de manière à être adjacente à la chambre de revêtement (12) et alignée avec celle-ci, la chambre de préchauffage (14) pouvant fonctionner pour préchauffer le premier article (20) supporté par le premier moyen formant support (22) à l'intérieur de la chambre de préchauffage (14) avant l'introduction par le premier moyen formant support (22) du premier article (20) dans la chambre de revêtement (12);
une première chambre de chargement (16, 18) adjacente à la chambre de préchauffage (14) et alignée avec celle-ci et opposée à la chambre de revêtement (12), la première chambre de chargement (16, 18) ayant un accès (40) par lequel le premier article (1) est chargé sur le premier moyen formant support (22) avant l'introduction consécutive par le premier moyen formant support (22) du premier article (20) dans les chambres de préchauffage et de revêtement (14, 12);
un second moyen formant support (22) pour supporter un second article (20) dans la chambre de préchauffage et de revêtement (12);
une seconde chambre de chargement (16, 18) adjacente à la première chambre de chargement (16, 18), la seconde chambre de chargement (16, 18) ayant un accès (40) par lequel le second article (20) est chargé sur le second moyen formant support (22);
une plate-forme mobile (24) dont la surface supérieure n'est pas située à plus de 2,5 cm au-dessus de la surface, la première et la seconde chambre de chargement (16, 18) étant supportées par la plate-forme mobile (24) de telle manière que leur mouvement provoque la mise en et hors d'alignement des première et seconde chambres de chargement (16, 18) avec la chambre de préchauffage (14); et
des appuis (44) supportant la plate-forme mobile (24) au-dessus de la surface.

8. Dispositif de dépôt physique en phase vapeur à faisceau d'électrons (10) selon la revendication 7, dans lequel la plate-forme mobile (24) peut se déplacer entre une première position dans laquelle la première chambre de chargement (16, 18) est alignée avec la chambre de préchauffage (14) et la seconde chambre de chargement (16, 18) n'est pas alignée avec la première chambre la chambre de préchauffage (14), une deuxième position dans laquelle la première chambre de chargement (16, 18) n'est pas alignée avec la chambre de préchauffage (14) et la seconde chambre de chargement (16, 18) est alignée avec la chambre de préchauffage (14), et une troisième position dans laquelle ni la première chambre de chargement (16, 18), ni la seconde le chambre de chargement (16,18) ne sont alignées avec la chambre de préchauffage (14).

9. Dispositif de dépôt physique en phase vapeur à faisceau d'électrons (10) selon la revendication 7, dans lequel la plate-forme mobile (24) comprend une première passerelle sur une première région de surface de la plate-forme mobile (24) adjacente à la première chambre de chargement (16,18), et une seconde passerelle sur une seconde surface de région de la plate-forme mobile (24) adjacente à la seconde chambre de chargement (16, 18).

10. Dispositif de dépôt physique en phase vapeur à faisceau d'électrons (10) selon la revendication 7, dans lequel les appuis (44) sont montés dans la surface.
